# EUROPÄISCHE PATENTSCHRIFT

(11) **EP 1 900 841 B1**
(45) Veröffentlichungstag und Bekanntmachung des Hinweises auf die Patenterteilung: **05.10.2011**
(21) Anmeldenummer: 07115921.4
(22) Anmeldetag: 07.09.2007
(51) Int. Cl.: C23C 4/12, C23C 16/453, B05B 7/02

(54) **Homogenisator für der Beschichtung von Oberflächen dienende Gasströme**
Homogenizer for gas streams for coating surfaces
Homogénéisateur pour courants de gaz pour le revêtement de surfaces

(30) Priorität: 12.09.2006 DE 102006043543
(43) Veröffentlichungstag der Anmeldung: 19.03.2008
(73) Patentinhaber: Innovent e.V., 07745 Jena (DE)
(72) Erfinder: Staude, Maik, 07768 Kahla (DE); Heft, Andreas, 07545 Gera (DE); Krippl, Gerhardt, 07646 Stadtroda (DE); Grünler, Bernd, 07937 Zeulenroda (DE); Schimanski, Arnd, 44329 Dortmund (DE); Tiller, Hans-Jürgen, 07749 Jena (DE)
(74) Vertreter: Liedtke, Markus

(56) Entgegenhaltungen:
- EP-A1- 0 029 809
- EP-A1- 0 158 468
- FR-A1- 2 518 429
- US-A1- 2006 127 599

## Beschreibung

Die Erfindung betrifft einen Homogenisator für der Beschichtung von Oberflächen dienende Gasströme.

Bei der Beschichtung von Oberflächen, beispielsweise zur Haftvermittlung oder zur Beeinflussung optischer Eigenschaften wie der Transmission werden möglichst gleichmäßige Schichtstärken im Nanometerbereich angestrebt. Gebräuchliche Verfahren zur Beschichtung von Oberflächen sind beispielsweise die flammengestützte Abscheidung und die Flammenpyrolyse von metallischen Oxiden. Hierzu werden so genannte Precursoren einem Trägergas in einem Brenner zugesetzt, die bei der Verbrennung des Trägergases thermisch umgesetzt und deren dabei entstehende Reaktionsprodukte, beispielsweise Metalloxide, auf der Oberfläche als Beschichtung angelagert werden. Für flächige Oberflächenbehandlung werden meist längliche Brenner verwendet, die mit ihrer Länge entsprechend vielen Einzelbohrungen versehen sind, die als Düsen fungieren. Des Weiteren sind zahlreiche andere Bauformen bekannt, welche eine gleichmäßige Verteilung der Einzelflammen auf bestimmte Länge zeigen, jedoch ein sehr inhomogenes Flammenbild bieten, zumindest bezüglich der Beschichtungsstärken im Nanometerbereich. Dies führt zu einer nicht unerheblichen Streifenbildung auf den zu beschichtenden Oberflächen. Diese Streifenbildung zeigt sich insbesondere bei sehr geringen Abständen zwischen Brenner und Substrat und hat einen erheblichen Einfluss auf Oberflächenprofile, Schichtdicken, Rauhigkeiten und die damit verbundenen physikalischen Eigenschaften. Des Weiteren wird der hohe Energieeintrag der üblichen Brenner z.B. für Beschichtungen nicht benötigt, und ist sogar in vielen Fällen, wie bei der Beschichtung von Kunststoffen für Haftvermittlungszwecke störend. Ein weiterer Nachteil herkömmlichen Brennerbauformen ist der hohe Gasverbrauch, der zur optimalen chemischen Umsetzung der Beschichtungsstoffe nötig ist. Um relativ homogene Schichten erzielen zu können, ist es nach den bekannten Verfahren erforderlich, einen großen Abstand zwischen der Flamme und der zu beschichtenden Oberfläche einzuhalten. Um auch in diesem Fall den an der Oberfläche für die Beschichtung notwendigen Energieeintrag sicherzustellen, ist eine größere Flamme erforderlich. Nachteilig ist dabei ein erheblicher Energieverlust in Form von Wärme.

Der Erfindung liegt die Aufgabe zu Grunde, einen Homogenisator anzugeben, der eine homogene Ausströmung eines Gasstroms auf eine zu beschichtende Oberfläche ermöglicht.

Die Aufgabe wird erfindungsgemäß gelöst durch einen Homogenisator mit den Merkmalen des Anspruchs 1.

Vorteilhafte Ausgestaltungen der Erfindung sind Gegenstand der Unteransprüche.

Der erfindungsgemäße Homogenisator für der Beschichtung von Oberflächen dienende Gasströme ist mit einer Einströmseite gasdicht auf einen Brenner oder eine Gasverteilungseinheit aufsetzbar. Er weist eine schlitzförmige Ausströmöffnung auf, die auf ihren Längsseiten von zwei einander gegenüber liegenden Führungsplatten und auf ihren Querseiten von zwei einander gegenüber liegenden Seitenführungsplatten begrenzt ist. Die Führungsplatten und Seitenführungsplatten umschließen zumindest einen Teil eines Raumes, dessen im Wesentlichen rechteckige Querschnittsfläche sich von der Einströmseite zur Ausströmöffnung hin durch eine geneigte Stellung mindestens einer der Führungsplatten verjüngt. Insbesondere weisen beide Führungsplatten eine Neigung auf. In den Brenner oder die Gasverteilungseinheit ist ein Gasstrom einleitbar, der zumindest ein Trägergas und einen Precursor oder eine Beschichtungskomponente enthält. Diese Substanzen können bereits gemischt oder auch einzeln in den Brenner oder die Gasverteilungseinheit eingeleitet werden. Aus der Gasverteilungseinheit oder dem Brenner wird der Gasstrom in den Homogenisator eingeleitet. Infolge der Verjüngung des Raumes entstehen Turbulenzen, die für eine Homogenisierung des Gasstromes, d.h. der darin enthaltenen Komponenten sorgen. Der homogenisierte Gasstrom wird aus der Ausströmöffnung in Richtung der zu beschichtenden Oberfläche ausgeströmt und an dieser die Beschichtungskomponente und/oder mindestens ein Reaktionsprodukt des Precursors angelagert. Der dem Trägergas zugesetzte Precursor wird infolge der Verbrennung des Trägergases im Homogenisator und/oder an der Austrittsöffnung chemisch zu mindestens einem Reaktionsprodukt umgesetzt und als Beschichtung auf der Oberfläche angelagert. Alternativ kann ein Precursor oder eine Beschichtungskomponente einem als Trägergas dienenden Gasstrom, insbesondere einem Heißgasstrom zugesetzt sein, der ohne Verbrennung aus der Ausströmöffnung ausgeströmt wird, wobei die Beschichtungskomponente oder ein Reaktionsprodukt des Precursors sich auf der Oberfläche anlagert. Brenner und Gasverteilungseinheiten sind Düsen oder Anordnungen von Düsen. Insbesondere zur flächigen Oberflächenbeschichtung sind längliche Brenner mit einer Vielzahl von Einzeldüsen gebräuchlich. Der Einsatz des auf den Brenner oder die Gasverteilungseinheit aufgesetzten Homogenisators sorgt einerseits für eine Homogenisierung des Precursors bzw. der Beschichtungskomponente im Trägergas, andererseits für einen homogenen Austritt des Gasstroms entlang der schlitzförmigen Ausströmöffnung, so dass sich, anders als bei einer nur mit dem Brenner stattfindenden Beschichtung keine oder nur geringe Inhomogenitäten in der Dicke der Beschichtung ergeben, da ein homogener Flammenbalken mit definierter Flammenhöhe aus der Ausströmöffnung austritt. Die Verjüngung des Raumes bewirkt außer der Homogenisierung auch eine Erhöhung des dynamischen Druckes des Gasstroms, was zu einer erhöhten Austrittsgeschwindigkeit des Gasstroms mit einem verringerten Verbrauch an Trägergas führt. Der Homogenisator ist so gebildet, dass keine der Düsen oder Öffnungen des Brenners oder der Gasverteilungseinheit verdeckt ist, um einen optimalen Gasdurchfluss zu ermöglichen. Die Verwendung eines solchen Homogenisators zur Beschichtung von Oberflächen ermöglicht wegen der Homogenität des Flammenbalkens einen sehr geringen Abstand zwischen dem Flammenbalken und der zu beschichtenden Oberfläche. Da deshalb die Flamme kleiner sein kann, sinkt auch der Energiebedarf. Vorteilhaft ist weiter die Verwendbarkeit eines herkömmlichen Brenners, der mit dem Homogenisator kostengünstig aufrüstbar ist und durch Entfernen desselben gegebenenfalls wieder in seinen ursprünglichen Zustand zurück versetzt werden kann. Als Gasströme sollen hier wie im Folgenden sowohl kalte als auch heiße Gasströme sowie brennende Gase verstanden werden.
In einer alternativen Ausführungsform ist der Gasstrom über eine Zuleitung in den Homogenisator einleitbar. Der separate Brenner bzw. die Gasverteilungseinheit entfallen hier, da der Homogenisator deren Aufgaben übernimmt. Weitere Wirkungen und Vorteile entsprechen den vorgenannten.

Die Verjüngung kann sich über den gesamten Bereich mindestens einer der Führungsplatten oder mindestens eines der Führungsplattensegmente zwischen einer Einströmöffnung des Homogenisators, die an die Düse bzw. die Gasverteilungseinheit oder die Zuleitung angrenzt, und der Ausströmöffnung oder über einen oder mehrere Teile dieses Bereiches erstrecken. Als Verjüngung soll hier auch eine lokale Einschnürung des Strömungsquerschnitts oder eine Folge solcher Einschnürungen verstanden werden, wobei sich der Strömungsquerschnitt nach der Einschnürung wieder vergrößert. Die Verjüngung kann linear oder nichtlinear erfolgen.

Die Verjüngung wird vorzugsweise erzielt, indem mindestens eine der Führungsplatten oder mindestens eines der Führungsplattensegmente eine Neigung auf weist. Insbesondere sind beide Führungsplatten oder alle Führungsplattensegmente mit einer solchen Neigung versehen. Die Verjüngung ist auf diese Weise mit flächigen Führungsplatten besonders einfach und kostengünstig zu realisieren, da in die Führungsplatten keine zusätzlichen Strukturen für die Verjüngung eingearbeitet oder solche auf die Führungsplatten aufgebracht werden müssen..

Erfindungsgemäß ist mindestens eine der Führungsplatten oder mindestens eines der Führungsplattensegmente so schwenkbar, dass eine Breite der Ausströmöffnung einstellbar ist. Insbesondere sind beide Führungsplatten synchron schwenkbar. Die Verstellung der Schlitzbreite ermöglicht eine Feinabstimmung der Charakteristik des aus der Ausströmöffnung austretenden Gasstromes, insbesondere der Höhe und Breite des Flammenbalkens, um Durchflussmenge und Energieeintrag an die zu beschichtende Oberfläche anzupassen. Die Einstellbarkeit der Führungsplattensegmente ermöglicht eine abschnittsweise Feinabstimmung. Durch die Größe der Flamme und die Durchflussmenge ist auch die Stärke der Beschichtung beeinflussbar.

Zur Verwendung mit länglichen Brennern oder Gasverteilungseinheiten ist die Einströmseite vorzugsweise passend zu dem Brenner oder der Gasverteilungseinheit länglich ausgebildet. Auf diese Weise können bekannte längliche Brenner, wie Rohrbrenner, ohne zusätzliche Adapter verwendet werden.

In einer bevorzugten Ausführungsform weisen die Ausströmöffnung und die Führungsplatten oder die Führungsplattensegmente eine an eine unebene zu beschichtende Oberfläche angepasste Form auf. Weist die Oberfläche beispielsweise eine gewölbte Form auf, so werden die Führungsplatten oder Führungsplattensegmente mit einer zu der Wölbung komplementären Form versehen, so dass sich ein definierter, vorzugsweise gleicher Abstand zwischen der Ausströmöffnung und der Oberfläche über deren gesamte Breite ergibt. In gleicher Weise ist der Homogenisator beispielsweise auch an eine Oberfläche mit gezackter Form anpassbar.

Vorzugsweise sind die Führungsplatten oder Führungsplattensegmente und/oder die Seitenführungsplatten als Blechplatten ausgebildet, um den hohen thermischen Anforderungen von Heißgasströmen oder angrenzenden Flammen gerecht zu werden ohne sich zu verziehen oder zu verwinden, so dass die Homogenität des Flammenbalkens sichergestellt ist. Unter Blechplatten sollen dabei sowohl Platten aus Feinblech mit Stärken von weniger als 3 mm als auch Platten aus Grobblech mit Stärken von mehr als 3 mm verstanden werden.

Vorzugsweise weisen die Führungsplatten oder Führungsplattensegmente im Bereich der Ausströmöffnung eine gebrochene Kante oder einen Radius auf, um Verwirbelungen beim Austritt des Gasstroms zu vermeiden, wodurch sich die Homogenität des Flammenbalkens zusätzlich verbessert.

Ausführungsbeispiele der Erfindung werden im Folgenden anhand von Zeichnungen näher erläutert.

Darin zeigen:
- Figur 1: eine Seitenansicht einer Anordnung mit einer zu beschichtenden Oberfläche, einem Brenner und einem Homogenisator zur Durchführung eines Verfahrens zur Beschichtung der Oberfläche,
- Figur 2: eine Ansicht der Anordung aus Figur 1 von vorn,
- Figur 3: eine Ansicht einer Anordnung mit einer zu beschichtenden, gewellten Oberfläche, einem Brenner und einem Homogenisator zur Durchführung eines Verfahrens zur Beschichtung der Oberfläche,
- Figur 4: eine Ansicht einer Anordnung mit einer zu beschichtenden, unstetigen Oberfläche, einem Brenner und einem Homogenisator zur Durchführung eines Verfahrens zur Beschichtung der Oberfläche,
- Figur 5: eine Ansicht einer Anordnung mit einem komplexen Körper mit vier unebenen zu beschichtenden Oberflächen, vier Brennern mit jeweils einem Homogenisator zur Durchführung eines Verfahrens zur Beschichtung der Oberflächen,
- Figur 6: eine perspektivische Ansicht eines Brenners mit zu einem Homogenisator gehörenden Führungsplattensegmenten und
- Figur 7: eine Draufsicht auf einen Homogenisator mit Führungsplattensegmenten.

Einander entsprechende Teile sind in allen Figuren mit den gleichen Bezugszeichen versehen.

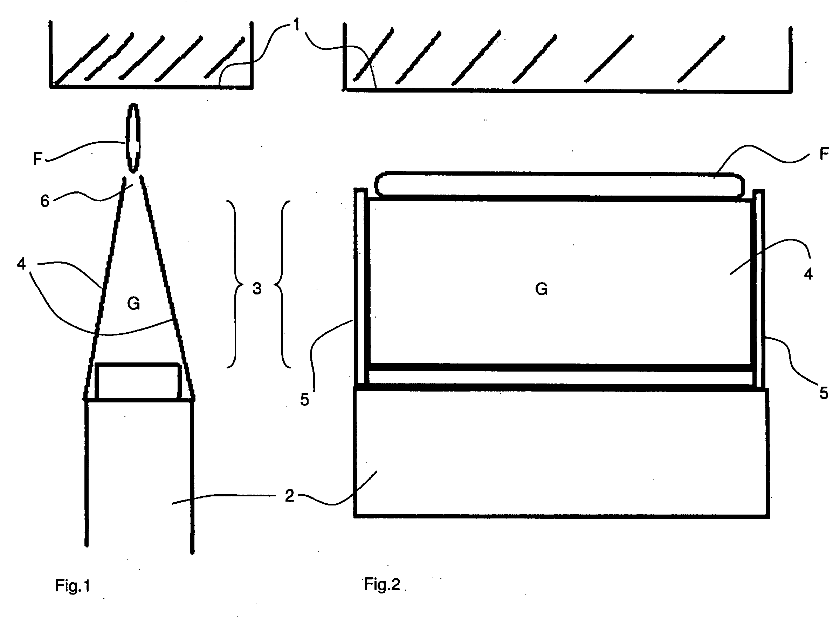

**Figur 1** zeigt eine Seitenansicht einer Anordnung mit einer zu beschichtenden Oberfläche 1, einem Brenner 2 und einem Homogenisator 3 zur Durchführung eines Verfahrens zur Beschichtung der Oberfläche 1. Dieselbe Anordnung ist auch in **Figur 2** gezeigt, jedoch in einer Ansicht von vorn.

In dem Verfahren zur Beschichtung der Oberfläche 1 wird in den länglich gestalteten Brenner 2 ein Gemenge G aus einem brennbaren Trägergas und einem Precursor eingeleitet. In einem Gasaustrittsbereich des Brenners 2 ist auf dem Brenner 2 ein Homogenisator 3 gasdicht angeordnet. Er umfasst zwei einander gegenüber liegende Führungsplatten 4 und zwei einander gegenüber liegende Seitenführungsplatten 5, die einen Raum mit einem rechtwinkligen Strömungsquerschnitt begrenzen. Die Führungsplatten 4 sind so gegeneinander geneigt, dass der Raum sich zu einer schlitzförmigen Ausströmöffnung 6 hin verjüngt. Beim Durchströmen des Homogenisators 3 bilden sich wegen des steigenden dynamischen Druckes infolge der Verjüngung Turbulenzen aus, die für eine Homogenisierung des Gemenges G sorgen. Außerdem strömt das Gemenge G so homogen aus der Ausströmöffnung 6, dass sich, wenn das Trägergas brennbar ist und entzündet wird, eine homogene balkenartige Flamme F ausbildet. Der Precursor wird in der Flamme F chemisch zu mindestens einem Reaktionsprodukt umgesetzt und dieses auf der Oberfläche 1 angelagert. Die Anlagerung erfolgt aufgrund der Homogenität der Flamme F mit definierter und außerordentlich gleichmäßiger Schichtdicke. Die Führungsplatten 4 sind in ihrer Neigung so verstellbar, dass sich eine unterschiedliche Breite der Ausströmöffnung 6 und infolgedessen unterschiedliche Strömungsgeschwindigkeiten des Gemenges G und damit unterschiedliche Längen der Flamme F ergeben. Figur 1 zeigt eine längere, Figur 2 eine kürzere Flamme infolge unterschiedlich eingestellter Führungsplatten 4. Die Verstellung kann beispielsweise durch Schwenken um jeweils eine in Längsrichtung des Brenners 2 liegende Achse an dem Ende der Führungsplatte 4, die an den Brenner 2 angrenzt, erfolgen. Die Führungsplatten 4 und Seitenführungsplatten 5 sind vorzugsweise aus Metallblech gebildet.

Da die Beschichtung der Oberfläche 1 mit dem Homogenisator 3 quasi eindimensional erfolgt, muss dieser relativ zur Oberfläche 1 verschoben werden, was sowohl durch eine Verschiebung der Oberfläche 1 als auch des Brenners 2 mit dem Homogenisator 3 erfolgen kann. Auf diese Weise kann eine definierte Beschichtungsdicke erzielt werden. Die Verschiebung erfolgt in Figur 1 in seitlicher Richtung und in Figur 2 in Normalrichtung zur Figur. Zur Beschichtung von Oberflächen 1 aus Glas können beispielsweise Transportbänder benutzt werden, auf denen das Glas unter der aus dem Homogenisator 3 austretenden Flamme F verschoben wird. Zur Durchführung mehrerer Beschichtungszyklen kann das Glas entsprechend häufig vor und zurück verschoben oder eine entsprechende Anzahl an Brennern 2 mit Homogenisatoren 3 verwendet werden.

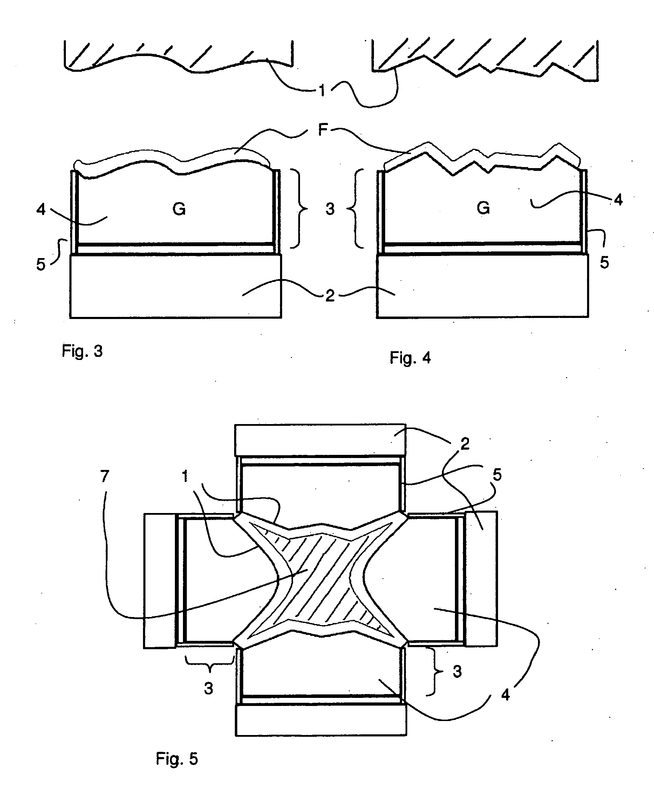

Die in **Figur 3** gezeigte Anordnung entspricht der in Figur 2 gezeigten mit dem Unterschied, dass die Oberfläche 1 uneben, hier wellig geformt ist. Die Führungsplatten 4 und damit die Ausströmöffnung 6 sind entsprechend dieser Oberflächenform gebildet, so dass die Flamme F überall den gleichen Abstand zur Oberfläche 1 aufweist.

Die in **Figur 4** gezeigte Anordnung entspricht der in Figur 3 gezeigten mit dem Unterschied, dass die Oberfläche 1 uneben, hier unstetig gezackt geformt ist. Die Führungsplatten 4 und damit die Ausströmöffnung 6 sind entsprechend dieser Oberflächenform gebildet, so dass die Flamme F überall den gleichen Abstand zur Oberfläche 1 aufweist.

In **Figur 5** ist ein komplexer Körper 7 in einer Querschnittsdarstellung gezeigt. Er weist vier unebene Oberflächen 1 auf, die beschichtet werden sollen. Hierzu sind vier Brenner 2 mit jeweils zugehörigen Homogenisatoren 3 angeordnet, deren Führungsplatten 4 entsprechend der durch sie zu beschichtenden Oberflächen 1 geformt sind. Für eine vollständige Beschichtung der Oberflächen des komplexen Körpers 7 wird dieser beispielsweise in Richtung seiner Längsausdehnung durch die Homogenisatoren 3 geschoben. Der Vorgang wird so oft wiederholt, bis die gewünschte Beschichtungsstärke erreicht ist.

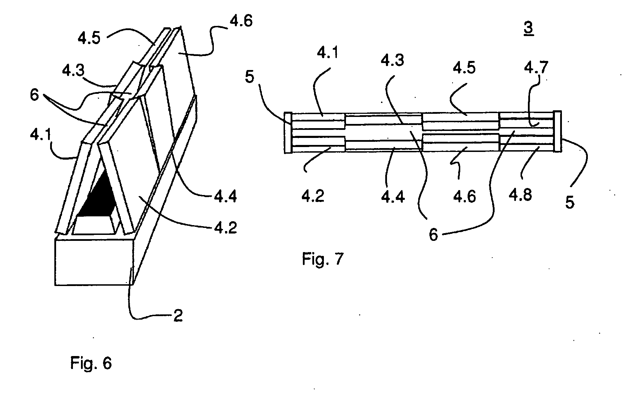

In **Figur 6** ist exemplarisch ein Brenner 2 mit zu einem Homogenisator 3 gehörenden Folgen von Führungsplattensegmenten 4.1 bis 4.6 gezeigt, die zur abschnittsweisen Verstellung der Breite der schlitzförmigen Ausströmöffnung 6 einzeln schwenkbar sind, um die Charakteristik der Flamme F oder des Gasstroms und somit die Beschichtungseigenschaften der Oberfläche 1 abschnittsweise einstellen zu können.

**Figur 7** zeigt eine Draufsicht auf einen Homogenisator 3 mit Folgen von Führungsplattensegmenten 4.1 bis 4.8 und Seitenführungsplatten 5, um die abschnittsweise unterschiedliche Breite der schlitzförmigen Ausströmöffnung 6 zu verdeutlichen.

Die Führungsplatten 4 oder Führungsplattensegmente 4.1 bis 4.n können im Bereich der Ausströmöffnung 6 eine gebrochene Kante oder einen Radius aufweisen, um Verwirbelungen beim Austritt des Gasstroms G zu vermeiden.

Statt des Brenners 2 kann eine ähnlich gestaltete Gasverteilungseinheit zum Einsatz kommen, in der beispielsweise ein mit einem Precursor dotierter Heißgasstrom als Trägergas ein Gemenge G bildet. Die Umsetzung des Precursors erfolgt beispielsweise ohne Flamme im Heißgasstrom oder mittels Stützflammen nach dem Austritt aus der Ausströmöffnung 6. Der Austritt des Gemenges G aus der Ausströmöffnung 6 erfolgt ebenfalls homogen, so dass eine ebenso gleichmäßige Beschichtung der Oberfläche 1 wie mit einem brennbaren Gas erreicht wird. Prinzipiell kann ein solcher Heißgasstrom oder ein kalter Gasstrom als Trägergas auch mit der Beschichtungskomponente beschickt werden, so dass eine Beschichtung ohne vorherige thermische Umsetzung direkt mit der Beschichtungskomponente erfolgt.

Alternativ kann der Homogenisator 3 selbst mit mindestens einer Zuleitung für die Einleitung eines Gasstroms oder Komponenten eines Gasstroms versehen sein, so, dass Brenner 2 bzw. Gasverteilungseinheit entfallen.

Die Verjüngung kann anders als mit geneigten Führungsplatten oder Führungsplattensegmenten erzielt werden. Beispielsweise kann sich die Verjüngung über den gesamten Bereich mindestens einer der Führungsplatten oder mindestens eines der Führungsplattensegmente zwischen einer Einströmöffnung des Homogenisators, die an die Düse bzw. die Gasverteilungseinheit oder die Zuleitung angrenzt, und der Ausströmöffnung oder über einen oder mehrere Teile dieses Bereiches erstrecken. Als Verjüngung soll auch eine lokale Einschnürung des Strömungsquerschnitts oder eine Folge solcher Einschnürungen verstanden werden, wobei sich der Strömungsquerschnitt nach der Einschnürung wieder vergrößert. Die Verjüngung kann linear oder nichtlinear erfolgen.

### BEZUGSZEICHENLISTE

- 1: Oberfläche
- 2: Brenner
- 3: Homogenisator
- 4: Führungsplatte
- 5: Seitenführungsplatte
- 6: Ausströmöffnung
- 7: Komplexer Körper
- F: Flamme
- G: Gasstrom

## Patentansprüche

1. Homogenisator (3) für der Beschichtung von Oberflächen (1) dienende Gasströme (G), dem auf einer Einströmseite ein Gasstrom oder Komponenten eines Gasstromes aus mindestens einer Zuleitung oder einem Brenner (2) oder einer Gasverteilungseinheit zuführbar ist oder sind und der eine schlitzförmige Ausströmöffnung (6) aufweist, die auf ihren Längsseiten von zwei einander gegenüber liegenden Führungsplatten (4) oder Folgen von Führungsplattensegmenten (4.1 bis 4.n) und auf ihren Querseiten von zwei einander gegenüber liegenden Seitenführungsplatten (5) begrenzt ist, wobei die Führungsplatten (4) oder Führungsplattensegmente (4.1 bis 4.n) und Seitenführungsplatten (5) zumindest einen Teil eines Raumes umschließen, dessen Querschnittsfläche sich von der Einströmseite zur Ausströmöffnung (6) hin verjüngt, wobei eine der Führungsplatten (4) oder mindestens eines der Führungsplattensegmente (4.1 bis 4.n) so schwenkbar ist, dass eine Breite der Ausströmöffnung (6) einstellbar ist.

2. Homogenisator (3) nach Anspruch 1, **dadurch gekennzeichnet, dass** sich die Querschnittsfläche durch eine geneigte Stellung mindestens einer der Führungsplatten (4) oder mindestens einer der Führungsplattensegmente (4.1 bis 4.n) verjüngt.

3. Homogenisator (3) nach einem der vorhergehenden Ansprüche, **dadurch gekennzeichnet, dass** die Einströmseite passend zu dem Brenner (2) oder der Gasverteilungseinheit länglich ausgebildet ist.

4. Homogenisator (3) nach einem der vorhergehenden Ansprüche, **dadurch gekennzeichnet, dass** die Ausströmöffnung (6) und die die Ausströmöffnung begrenzenden Ränder der Führungsplatten (4) oder der Führungsplattensegmente (4.1 bis 4.n) eine an eine unebene zu beschichtende Oberfläche (1) angepasste Form aufweisen.

5. Homogenisator (3) nach einem der vorhergehenden Ansprüche, **dadurch gekennzeichnet, dass** die Führungsplatten (4) oder Führungsplattensegmente (4.1 bis 4.n) und/oder die Seitenführungsplatten (5) als Blechplatten ausgebildet sind.

6. Homogenisator (3) nach einem der vorhergehenden Ansprüche, **dadurch gekennzeichnet, dass** aus der Ausströmöffnung (6) ein Heißgasstrom oder ein brennbares Gasgemisch ausströmbar ist.

7. Homogenisator (3) nach einem der vorhergehenden Ansprüche, **dadurch gekennzeichnet, dass** die Führungsplatten (4) oder Führungsplattensegmente (4.1 bis 4.n) im Bereich der Ausströmöffnung (6) eine gebrochene Kante oder einen Radius aufweisen.

8. Homogenisator (3) nach einem der vorhergehenden Ansprüche, **dadurch gekennzeichnet, dass** dem Gasstrom (G) im oder vor dem Brenner (2) oder in oder vor der Gasverteilungseinheit mindestens ein Precursor oder eine Beschichtungskomponente zusetzbar ist.

## Claims

1. Homogenizer (3) for gas streams (G) for coating surfaces (1), to which homogenizer (3) a gas stream or components of a gas stream can be supplied on an inflow side from at least one feed line or a burner (2) or a gas distribution unit and which has a slot-like outflow opening (6), which is bounded on its longitudinal sides by two opposite guide plates (4) or sequences of guide plate segments (4.1 to 4.n) and on its transverse sides by two opposite lateral guide plates (5), wherein the guide plates (4) or guide plate segments (4.1 to 4.n) and lateral guide plates (5) enclose at least a part of a space, the cross-sectional area of which narrows from the inflow side to the outflow opening (6), wherein one of the guide plates (4) or at least one of the guide plate segments (4.1 to 4.n) can be pivoted such that a width of the outflow opening (6) can be set.

2. Homogenizer (3) according to Claim 1, **characterized in that** the cross-sectional area narrows by way of an inclined position of at least one of the guide plates (4) or at least one of the guide plate segments (4.1 to 4.n).

3. Homogenizer (3) according to either of the preceding claims, **characterized in that** the inflow side is formed in an elongate manner that matches the burner (2) or the gas distribution unit.

4. Homogenizer (3) according to one of the preceding claims, **characterized in that** the outflow opening (6) and the edges, bounding the outflow opening, of the guide plates (4) or of the guide plate segments (4.1 to 4.n) have a form that matches an uneven surface (1) to be coated.

5. Homogenizer (3) according to one of the preceding claims, **characterized in that** the guide plates (4) or the guide plate segments (4.1 to 4.n) and/or the lateral guide plates (5) are formed as metal sheets.

6. Homogenizer (3) according to one of the preceding claims, **characterized in that** a hot-gas stream or a combustible gas mixture can flow out of the outflow opening (6).

7. Homogenizer (3) according to one of the preceding claims, **characterized in that** the guide plates (4) or guide plate segments (4.1 to 4.n) have a broken edge or a radius in the region of the outflow opening (6).

8. Homogenizer (3) according to one of the preceding claims, **characterized in that** at least one precursor or coating component can be added to the gas stream (G) in or upstream of the burner (2) or in or upstream of the gas distribution unit.

## Revendications

1. Homogénéisateur (3) pour des flux de gaz (G) destinés au revêtement de surfaces (1), lequel peut être alimenté, du côté de l'entrée des flux, par un flux de gaz ou des composants d'un flux de gaz en provenance d'au moins une ligne d'alimentation ou d'un brûleur (2) ou d'une unité de distribution de gaz et lequel présente une sortie des flux (6) en forme de fente dont les côtés longitudinaux sont définis par deux plaques de guidage (4) ou suites de segments de plaques de guidage (4.1 à 4.n) disposées l'une en face de l'autre et dont les côtés transversaux sont définis par deux plaques de guidage latérales (5) disposées l'une en face de l'autre, les plaques de guidage (4) ou suites de segments de plaques de guidage (4.1 à 4.n) et les plaques de guidage latérales (5) entourant au moins une partie d'un espace dont la superficie de section transversale s'amenuise en partant du côté de l'entrée des flux vers la sortie des flux (6), l'une des plaques de guidage (4) ou au moins un des segments de plaques de guidage (4.1 à 4.n) pouvant être orienté(e) de façon à pouvoir régler la largeur de la sortie des flux (6).

2. Homogénéisateur (3) selon la revendication 1, **caractérisé en ce qu'**une position inclinée d'au moins une des plaques de guidage (4) ou d'au moins un des segments de plaques de guidage (4.1 à 4.n) permet de réaliser un amenuisement de ladite superficie de section transversale.

3. Homogénéisateur (3) selon l'une des revendications précédentes, **caractérisé en ce que** le côté de l'entrée des flux est d'une forme allongée, en adéquation avec le brûleur (2) ou l'unité de distribution de gaz.

4. Homogénéisateur (3) selon l'une des revendications précédentes, **caractérisé en ce que** la sortie des flux (6) et les bords des plaques de guidage (4) ou des segments de plaques de guidage (4.1 à 4.n) définissant la sortie des flux présentent une forme adaptée à une surface (1) non plane destinée à être revêtue.

5. Homogénéisateur (3) selon l'une des revendications précédentes, **caractérisé en ce que** les plaques de guidage (4) ou les segments de plaques de guidage (4.1 à 4.n) et/ou les plaques de guidage latérales (5) sont réalisés sous forme de plaques en tôle.

6. Homogénéisateur (3) selon l'une des revendications précédentes, **caractérisé en ce que** l'on peut faire sortir par la sortie des flux (6) un flux de gaz chaud ou un mélange de gaz combustible.

7. Homogénéisateur (3) selon l'une des revendications précédentes, **caractérisé en ce que** les plaques de guidage (4) ou les segments de plaques de guidage (4.1 à 4.n) présentent, dans la zone de la sortie des flux (6), un bord discontinu ou un rayon.

8. Homogénéisateur (3) selon l'une des revendications précédentes, **caractérisé en ce qu'**au moins un précurseur ou un composant de revêtement peut être ajouté au flux de gaz (G) au sein ou en amont du brûleur (2) ou bien au sein ou en amont de l'unité de distribution de gaz.
